(19) Europäisches Patentamt / European Patent Office / Office européen des brevets

(11) **EP 2 278 704 A1**

(12) **DEMANDE DE BREVET EUROPEEN**

(43) Date de publication:
26.01.2011 Bulletin 2011/04

(51) Int Cl.:
*H03F 1/02* (2006.01)  *H03F 3/24* (2006.01)

(21) Numéro de dépôt: 10170386.6

(22) Date de dépôt: 22.07.2010

(84) Etats contractants désignés:
AL AT BE BG CH CY CZ DE DK EE ES FI FR GB GR HR HU IE IS IT LI LT LU LV MC MK MT NL NO PL PT RO SE SI SK SM TR
Etats d'extension désignés:
BA ME RS

(30) Priorité: 24.07.2009 FR 0955197

(71) Demandeurs:
• STmicroelectronics SA
92120 Montrouge (FR)
• Centre National de la Recherche Scientifique (CNRS)
75016 Paris (FR)

(72) Inventeurs:
• Belot, Didier
38140, RIVES (FR)
• Leyssenne, Laurent
33400, TALENCE (FR)
• Kerherve, Eric
33400, TALENCE Cédex (FR)
• Deval, Yann
33800, BORDEAUX (FR)

(74) Mandataire: Zapalowicz, Francis
Casalonga & Partners
Bayerstrasse 71/73
80335 München (DE)

(54) **Procédé et dispositif d'amplification de puissance d'un signal radiofréquence.**

(57) Circuit d'amplification de puissance d'un signal radiofréquence comprenant une entrée de signal (2) pour recevoir le signal radiofréquence, un étage d'amplification (4) couplé à l'entrée de signal (2) et possédant au moins un transistor de puissance, et un étage de polarisation (5) pour délivrer une tension de polarisation à l'étage d'amplification (4), un étage de traitement (6) comportant une entrée de traitement (13) couplée à l'entrée de signal (2), une sortie de traitement (15) pour délivrer un courant de polarisation modulé au moins en amplitude à l'étage de polarisation (5) et des moyens de modulation en amplitude (17) couplés entre l'entrée (13) et la sortie de traitement (15) et configurés pour déterminer un signal d'enveloppe représentatif de l'enveloppe du signal radiofréquence, pour moduler l'amplitude du signal d'enveloppe à partir d'une consigne de tension variable et pour élaborer le courant de polarisation modulé en amplitude à partir du signal d'enveloppe modulé.

FIG.1

EP 2 278 704 A1

## Description

L'invention concerne l'amplification de puissance d'un signal, notamment radiofréquence, en particulier celle réalisée dans la chaîne de transmission d'un téléphone mobile cellulaire.

Actuellement, les moyens d'amplification de puissance comprennent des transistors de puissance que l'on doit polariser, à l'aide d'une tension de polarisation, pour que ceux-ci puissent amplifier le signal radiofréquence à émettre vers une station de base, par exemple.

En général, la tension de polarisation des transistors de puissance peut être contrôlée de façon adaptative à l'aide d'alimentations à découpage, ou hacheurs, mais ces hacheurs sont difficiles à intégrer, notamment dans des téléphones mobiles cellulaires, et ils ont comme inconvénients d'entraîner des pertes de puissance lors du fonctionnement des transistors de puissance.

Par ailleurs, le signal radiofréquence destiné à être amplifié peut comporter un signal d'enveloppe qui n'est pas constant. C'est le cas de la norme W-CDMA, « Wideband Code Division Multiple Access » en langue anglaise, c'est-à-dire « Accès Multiple avec Répartition par Code - Large bande », qui est utilisé dans la communication radio de troisième génération. Lorsque le signal radiofréquence comporte un signal d'enveloppe modulé, la linéarité et le rendement des transistors de puissance sont diminués.

Pour des transistors de puissance classiques, par exemple de classe A, la tension de polarisation du transistor peut être choisi très basse afin d'augmenter le rendement du transistor. Mais en choisissant une tension de polarisation trop faible, on augmente la distorsion, c'est-à-dire les harmoniques parasites dans et autour du signal amplifié.

Selon un mode de mise en oeuvre et de réalisation il est proposé d'améliorer le rendement et la linéarité d'un amplificateur de puissance d'un signal radiofréquence.

Il est également proposé en particulier de réaliser une telle amplification de puissance avec un moyen simple, peu onéreux, de taille réduite et qui consomme peu de courant afin de pouvoir être embarqué dans un téléphone mobile cellulaire.

Selon un aspect, il est proposé un procédé d'amplification de puissance d'un signal radiofréquence comprenant une amplification du signal radiofréquence avec au moins un transistor de puissance.

Ce procédé comprend une détermination d'un signal d'enveloppe représentatif de l'enveloppe du signal radiofréquence, une élaboration d'un courant de polarisation modulé au moins en amplitude à partir du signal d'enveloppe et d'une consigne de tension variable, et une polarisation du ou des transistors de puissance à partir du courant de polarisation modulé.

Ainsi, on améliore le rendement et la linéarité des transistors de puissance quelle que soit la modulation du signal radiofréquence.

En particulier, on permet d'augmenter le rendement lorsque le signal radiofréquence a une puissance faible sans dégradation significative de la linéarité.

En outre, ce procédé n'est pas lié à une technologie particulière de transistors de puissance et peut être appliqué à tout type de transistors comme des transistors de type MOS, ou « Metal Oxide Semiconductor » en langue anglaise, ou « semi-conducteur à oxyde de métal», de type MESFET ou « Metal Semiconductor Field Effect Transistor » en langue anglaise, ou « transistor à effet de champ à métal », etc...

Avantageusement, la détermination du signal d'enveloppe comprend un auto mélange du signal radiofréquence et l'élaboration du courant de polarisation modulé au moins en amplitude comprend une modulation en amplitude du signal d'enveloppe en utilisant la consigne de tension variable.

Selon un mode de mise en oeuvre, le procédé comprend une élaboration de la consigne de tension variable à partir d'une cartographie établie en fonction de la puissance moyenne du signal radiofréquence.

Avantageusement, cette cartographie est établie en fonction de la norme régissant la communication radiofréquence.

Selon un autre mode de mise en oeuvre, le procédé comprend un calcul d'une tension d'enveloppe du signal amplifié par le ou les transistors de puissance, et dans lequel la consigne de tension variable est élaborée à partir d'une consigne de tension en boucle ouverte et de la tension d'enveloppe calculée.

L'élaboration du courant de polarisation modulé en amplitude peut comprendre une élaboration d'un gain variable à partir de la consigne de tension variable, le courant de polarisation modulé en amplitude étant élaboré à partir du gain variable et du signal d'enveloppe.

Avantageusement, ce gain variable peut être positif ou négatif pour que le rendement et la linéarité du transistor de puissance puissent être améliorés quelle que soit la puissance du signal radiofréquence, faible ou élevée.

On améliore d'autant mieux le rendement et la linéarité des transistors de puissance avec un gain négatif lorsque la puissance du signal radiofréquence est faible. Inversement, on améliore d'autant mieux le rendement et la linéarité des transistors de puissance avec un gain positif lorsque la puissance du signal radiofréquence est élevée.

Le procédé peut également comprendre une élaboration d'un courant de polarisation modulé en amplitude et en phase à partir d'une modulation en phase du courant de polarisation modulé en amplitude, et une polarisation du ou des transistors de puissance à partir du courant de polarisation modulé en amplitude et en phase.

A l'aide d'un courant de polarisation modulé à la fois en amplitude et en phase, on maîtrise la polarisation des transistors de puissance quelle que soit la modulation en phase et en amplitude du signal radiofréquence.

La modulation en phase peut comprendre une avance ou un retard de phase du courant de polarisation modulé en amplitude par rapport à la phase de l'enveloppe du signal radiofréquence.

Le procédé peut également comprendre une addition du courant de polarisation modulé avec une consigne de courant variable.

Le procédé peut en outre comprendre une élaboration de la consigne de courant variable à partir d'une cartographie établie en fonction des caractéristiques du ou des transistors de puissance.

Selon un autre aspect, il est proposé un circuit d'amplification de puissance d'un signal radiofréquence comprenant une entrée de signal pour recevoir le signal radiofréquence, un étage d'amplification couplé à l'entrée de signal et possédant au moins un transistor de puissance, et un étage de polarisation pour délivrer une tension de polarisation à l'étage d'amplification.

Selon une caractéristique générale de cet autre aspect, ce circuit comprend en outre un étage de traitement comportant une entrée de traitement couplée à l'entrée de signal, une sortie de traitement pour délivrer un courant de polarisation modulé au moins en amplitude à l'étage de polarisation et des moyens de modulation en amplitude couplés entre l'entrée et la sortie de traitement et configurés pour déterminer un signal d'enveloppe représentatif de l'enveloppe du signal radiofréquence, pour moduler l'amplitude du signal d'enveloppe à partir d'une consigne de tension variable et pour élaborer le courant de polarisation modulé en amplitude à partir du signal d'enveloppe modulé.

Avantageusement, les moyens de modulation en amplitude comprennent un étage d'auto mélange du signal radiofréquence.

Les moyens de modulation en amplitude peuvent également comprendre un étage d'interface de polarisation configuré pour élaborer un gain variable à partir de la consigne de tension variable, et pour moduler l'amplitude du signal d'enveloppe à partir du gain variable élaboré.

Selon un mode de réalisation, l'étage de traitement comprend des moyens pour élaborer la consigne de tension variable à partir d'une cartographie établie en fonction de la puissance moyenne du signal radiofréquence.

Selon un autre mode de réalisation, l'étage de traitement comprend des moyens de soustraction et des moyens de calcul couplés entre la sortie de l'étage d'amplification et les moyens de soustraction et configurés pour calculer la tension d'enveloppe du signal amplifié par le ou les transistors de puissance, lesdits moyens de soustraction étant configurés pour élaborer la consigne de tension variable à partir de la différence entre une consigne de tension en boucle ouverte et ladite tension d'enveloppe calculée.

L'étage de traitement peut comprendre en outre des moyens de modulation en phase couplés entre la sortie des moyens de modulation en amplitude et la sortie de traitement et configurés pour élaborer un courant de polarisation modulé en amplitude et en phase à partir du courant de polarisation modulé en amplitude.

Les moyens de modulation en phase peuvent comprendre un filtre, de type intégrateur et différentiateur ayant des fréquences de coupure variables par l'intermédiaire de deux gains en courant variables, afin de déphaser le courant de polarisation modulé en amplitude par rapport à la phase de l'enveloppe du signal radiofréquence.

Ainsi, on peut utiliser un filtre de type intégrateur de manière à élaborer un courant de polarisation modulé qui est en retard de phase, ou utiliser un filtre de type différentiateur pour élaborer un courant de polarisation modulé qui est en avance de phase, les déphasages étant réalisés par rapport à la phase de l'enveloppe du signal radiofréquence.

L'étage de traitement peut comprendre en outre des moyens de sommation de courants couplés entre la sortie des moyens de modulation en phase et la sortie des moyens de traitement et configurés pour additionner le courant de polarisation modulé avec une consigne de courant variable.

L'étage de traitement peut également comprendre des moyens pour élaborer la consigne de courant variable à partir d'une cartographie établie en fonction des caractéristiques du ou des transistors de puissance.

Le ou les transistors de puissance peuvent comporter chacun une électrode de commande pour recevoir la tension de polarisation.

Par ailleurs, l'étage de polarisation peut comprendre trois transistors qui forment, avec le transistor de puissance, une structure de miroir de courant ayant un facteur d'amplification en bande de base. Cette structure de miroir de courant peut comporter une électrode de commande pour recevoir le courant de polarisation modulé.

En outre, le circuit peut posséder une architecture différentielle.

Selon un autre aspect, il est également proposé un appareil de communication sans fil comprenant un circuit d'amplification de puissance d'un signal radiofréquence tel que décrit ci avant.

D'autres avantages et caractéristiques apparaîtront à l'examen de la description détaillée de modes de mise en oeuvre et de réalisations de l'invention, nullement limitatifs, et des dessins annexés sur lesquels :

- la figure 1 illustre de façon schématique un mode de réalisation d'un circuit d'amplification de puissance d'un signal radiofréquence ;

- la figure 2 illustre de façon schématique un autre mode de réalisation d'un circuit d'amplification de puissance d'un signal radiofréquence ;
- la figure 3 illustre de façon schématique un mode de réalisation des moyens de modulation en amplitude du signal radiofréquence ;
- la figure 4 illustre de façon schématique un mode de réalisation d'un filtre de type intégrateur et différentiateur ;
- la figure 5 illustre de façon schématique un mode de réalisation d'un étage de polarisation et d'un étage d'amplification ;
- la figure 6 illustre de façon schématique des courbes de rendement de transistors de puissance ;
- la figure 7 illustre de façon schématique des courbes de linéarité de transistors de puissance ; et
- la figure 8 illustre de façon schématique les principales étapes d'un mode de mise en oeuvre d'un procédé d'amplification de puissance d'un signal radiofréquence.

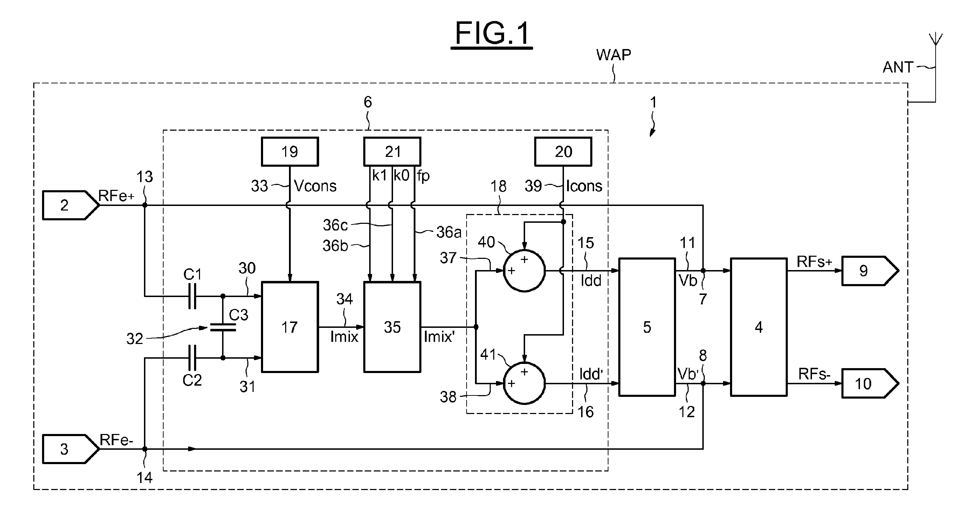

Sur la figure 1 on a représenté un mode de réalisation d'un circuit d'amplification de puissance 1 d'un signal radiofréquence à architecture différentielle, bien que l'invention puisse être appliquée à un circuit d'amplification à architecture à entrée unique (« single ended »).

Le circuit d'amplification de puissance 1 comprend une première entrée de signal 2 et une deuxième entrée de signal 3 pour recevoir respectivement le signal radiofréquence différentiel RFe+, RFe-.

Ce circuit est dans cet exemple non limitatif incorporé dans la chaîne d'émission radiofréquence d'un appareil de communication sans fil WAP, tel qu'un téléphone mobile cellulaire.

Le circuit d'amplification de puissance 1 comprend en outre un étage d'amplification 4, un étage de polarisation 5 et un étage de traitement 6.

L'étage d'amplification 4 comprend deux entrées 7, 8 couplées respectivement aux entrées de signal 2, 3, et deux sorties 9, 10. Cet étage d'amplification 4 comprend un ou des transistors de puissance configurés pour amplifier le signal radiofréquence différentiel RFe+, RFe- et pour délivrer sur ses deux sorties 9, 10, respectivement un signal amplifié différentiel RFs+, RFs-. Les deux sorties 9 et 10 sont ici couplées à une antenne ANT de l'appareil WAP.

L'étage de polarisation 5 comprend deux sorties 11, 12 couplées respectivement aux deux entrées 7, 8 de l'étage d'amplification 4. L'étage de polarisation 5 est apte à délivrer deux tensions de polarisation (Vb, Vb'), identiques et de mode commun, afin de polariser le ou les transistors de puissance de l'étage d'amplification 4. Ces deux tensions de polarisation (Vb, Vb') s'appliquent respectivement sur les deux entrées 7, 8 de l'étage d'amplification 4. En outre, cet étage de polarisation 5 est apte à recevoir deux courants de polarisation modulés identiques et de mode commun Idd, Idd', délivrés par l'étage de traitement 6.

L'étage de traitement 6 comprend deux entrées de traitement 13, 14 couplées respectivement à la première et à la deuxième entrée de signal 2, 3 et deux sorties de traitement 15, 16 qui sont couplées à l'étage de polarisation 5.

L'étage de traitement 6 comprend également des moyens de modulation en amplitude 17, des moyens de modulation en phase 35, des moyens de sommation de courants 18, des moyens 19 pour élaborer une consigne de tensions variable Vcons, des moyens 20 pour élaborer une consigne de courant variable Icons et des moyens 21 pour élaborer une consigne de fréquence de coupure variable fp, et deux consignes de gain en courant variables k0 et k1.

L'étage de traitement 6 est configuré pour recevoir le signal radiofréquence différentiel RFe+, RFe- afin d'élaborer un courant de polarisation modulé en amplitude Imix, de préférence également en phase Imix', ce courant de polarisation modulé Imix, ou Imix' étant destiné à l'étage de polarisation 5.

Les moyens de modulation en amplitude 17 comportent deux entrées 30 et 31 couplées respectivement à la première entrée de traitement 13 et à la deuxième entrée de traitement 14. De préférence, l'étage de traitement peut comprendre un diviseur capacitif 32 couplé entre les entrées de traitement 13, 14 et les entrées 30, 31 des moyens de modulation en amplitude 17.

Le diviseur capacitif 32 comprend une première capacité C1 montée en série entre la première entrée de traitement 13 et la première entrée 30 des moyens de modulation en amplitude 17, une deuxième capacité C2 montée en série entre la deuxième entrée de traitement 14 et la deuxième entrée 31 des moyens de modulation en amplitude 17, et une troisième capacité C3 montée en parallèle des deux entrées 30, 31 des moyens de modulation en amplitude 17. Ce diviseur capacitif 32 permet d'atténuer le signal radiofréquence différentiel RFe+, RFe-, il évite ainsi que l'on prélève trop de puissance du signal radiofréquence différentiel d'entrée RFe+, RFe-. Le diviseur capacitif 32 permet en outre de maintenir les moyens de modulation en amplitude 17 dans un régime linéaire quel que soit le niveau de puissance du signal radiofréquence différentiel d'entrée RFe+, RFe-.

Les moyens de modulation en amplitude 17 sont configurés pour déterminer le signal d'enveloppe du signal radiofréquence différentiel RFe+, RFe-. On notera que le signal d'enveloppe d'un signal radiofréquence correspond à un signal en bande de base représentant les variations globales, mais non les variations instantanées, de l'amplitude du signal radiofréquence d'origine. Le signal d'enveloppe représente donc le contour des maxima du signal radiofréquence d'origine et ne comprend pas les variations instantanées correspondant aux informations en phase du signal d'origine.

Les moyens de modulation en amplitude 17 reçoivent également la consigne de tension variable Vcons transmise par une connexion 33.

Par ailleurs, les moyens de modulation en amplitude 17 sont configurés pour élaborer un gain variable β à partir de la consigne de tension variable Vcons, et sont en outre configurés pour moduler l'amplitude du signal d'enveloppe à partir du gain variable β élaboré.

Enfin, les moyens de modulation en amplitude 17 sont également configurés pour élaborer le courant de polarisation modulé en amplitude Imix à partir du signal d'enveloppe modulé, et pour délivrer ce courant Imix sur une sortie 34 des moyens de modulation en amplitude 17.

L'étage de traitement 6 peut en outre comprendre un filtre 35 de type intégrateur et différentiateur, noté filtre en bande de base, couplé entre la sortie 34 des moyens de modulation en amplitude 17 et les moyens de sommation de courants 18. De manière générale, le filtre en bande de base 35 permet de lisser le courant de polarisation modulé en amplitude Imix afin d'éliminer la fréquence porteuse des informations utiles du signal Imix et de conserver uniquement l'enveloppe du signal. Plus particulièrement, le filtre en bande de base 35 permet de moduler en phase le courant de polarisation modulé en amplitude Imix. Le courant Imix' résultant comporte une avance ou un retard de phase par rapport à la phase de l'enveloppe du signal radiofréquence différentiel RFe+, RFe-. Ce retard ou avance de phase s'avère avantageux pour augmenter la linéarité du signal radiofréquence amplifié et pour compenser la distorsion de phase introduite par l'étage d'amplification 4. Les fréquences de coupure (zéro et pôle) du filtre en bande de base 35 sont variables et peuvent être modifiées à partir de la consigne de fréquence de coupure fp et des consignes de gain en courant k0 et k1, qui sont élaborées par les moyens 21 et transmises aux moyens de modulation en phase 35 depuis respectivement des connexions 36a, 36b et 36c.

Les moyens de sommation de courants 18 sont aptes à recevoir le courant de polarisation modulé en amplitude Imix, ou également modulé en phase Imix', via des connexions 37, 38 et à sommer, à partir d'une addition 40, 41, le courant de polarisation modulé Imix, ou Imix' avec la consigne de courant variable Icons émise depuis les moyens 20 via une connexion 39. Les moyens de sommation de courants 18 permettent ainsi d'émettre deux courants de polarisation identiques et de mode commun, modulés en amplitude et en phase Idd, Idd', respectivement sur les sorties de traitement 15, 16.

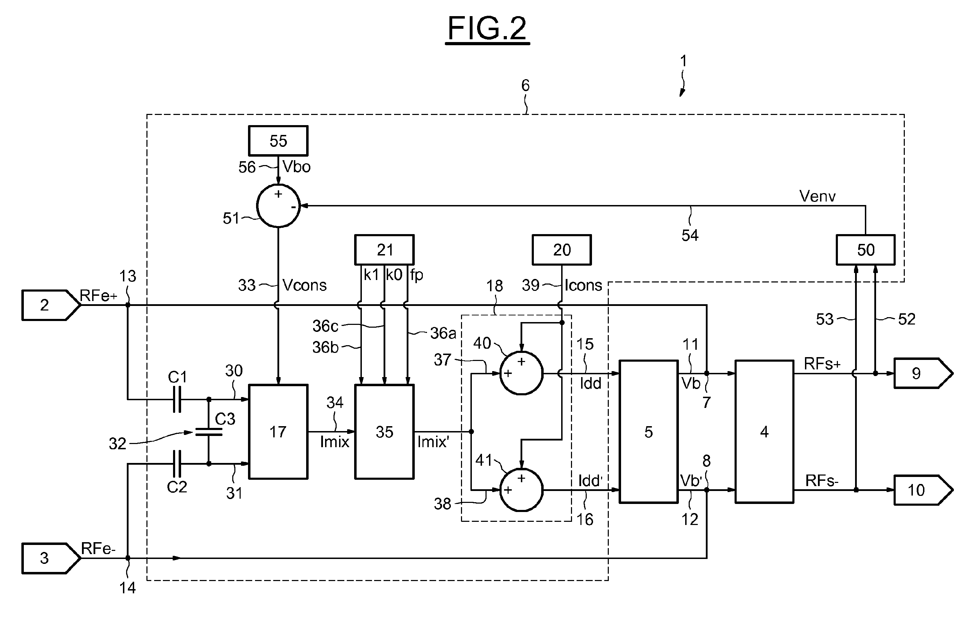

Sur la figure 2, on a représenté un autre mode de réalisation du circuit d'amplification de puissance 1 d'un signal radiofréquence à architecture différentielle. On a également reporté sur cette figure certaines références de la figure 1.

Dans ce mode de réalisation, le circuit d'amplification de puissance 1 comporte une architecture en boucle fermée afin d'élaborer deux courants de polarisation, identiques et de mode commun, modulés Idd, Idd', en fonction respectivement du signal amplifié différentiel RFs+, RFs-.

Dans ce circuit d'amplification de puissance 1, l'étage de traitement 6 comprend :

- des moyens de calcul d'enveloppe 50, et
- des moyens de soustraction 51.

Les moyens de calcul d'enveloppe 50 sont aptes à recevoir les signaux amplifiés différentiels RFs+, RFs- transmis respectivement par des connexions 52, 53 depuis l'étage d'amplification 4. Ces moyens de calcul d'enveloppe 50 permettent de calculer la tension d'enveloppe du signal amplifié Venv, à partir d'un traitement de signal comme par exemple un filtrage, pour la transmettre vers les moyens de soustraction 51 via une connexion 54.

Les moyens de soustraction 51 permettent d'élaborer la consigne de tension variable Vcons à partir de la différence entre une consigne de tension en boucle ouverte Vbo, élaborée par des moyens 55, et la tension d'enveloppe du signal amplifié Venv. La consigne de tension en boucle ouverte Vbo est émise depuis les moyens 55 via une connexion 56.

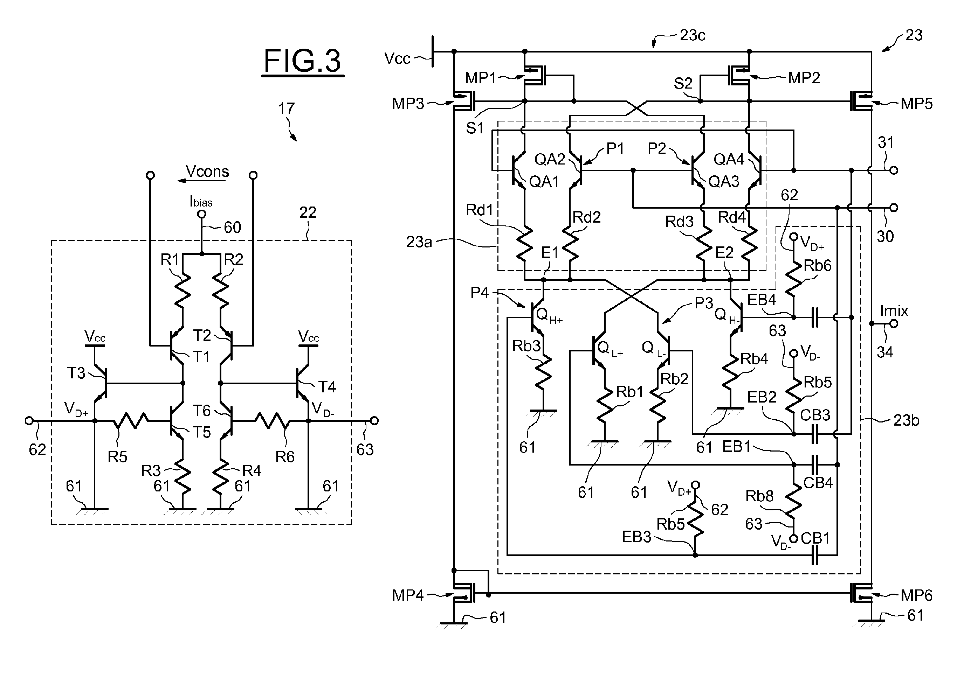

Sur la figure 3, on a représenté un mode de réalisation des moyens de modulation en amplitude 17 du signal radiofréquence.

On a également reporté sur cette figure certaines références des figures précédentes 1 et 2.

Les moyens de modulation en amplitude 17 comprennent un étage de transformation de tension 22 et un étage d'élaboration 23 du courant de polarisation modulé en amplitude Imix.

L'étage de transformation de tension 22 permet de transformer la consigne de tension variable Vcons reçue depuis les moyens 19 en une tension de polarisation différentielle VD+, VD-. En outre, cet étage de transformation de tension 22 reçoit un courant de polarisation Ibias par une entrée 60. Ce premier étage de transformation de tension 22 comprend six transistors T1 à T6 et six résistances R1 à R6.

La première résistance R1 est couplée entre l'entrée 60 et la source du premier transistor T1, la deuxième résistance R2 est couplée entre l'entrée 60 et la source du deuxième transistor T2. Les premier et deuxième transistor T1, T2 reçoivent la consigne de tension variable Vcons sur leur grille. Le drain du premier transistor T1 est couplé à la grille du troisième transistor T3 et le drain du deuxième transistor T2 est couplé à la grille du quatrième transistor T4.

Le troisième transistor T3 a son drain couplé à une tension d'alimentation Vcc et a sa source couplée à une masse 61. Le quatrième transistor T4 a son drain couplé à la tension d'alimentation Vcc et a sa source couplée à la masse 61.

Par ailleurs, le cinquième transistor T5 a son drain couplé au drain du premier transistor T1 et a sa source couplée à la troisième résistance R3. Le sixième transistor T6 a son drain couplé au drain du deuxième transistor T2 et a sa source couplée à la quatrième résistance R4. Les troisième et quatrième résistances R3 et R4 sont également couplées à la masse 61. La cinquième résistance R5 est couplée entre la grille du cinquième transistor T5 et la source du troisième transistor T3. La sixième résistance R6 est couplée entre la grille du sixième transistor T6 et la source du quatrième transistor T4.

L'étage de transformation de tension 22 est configuré pour élaborer la première tension de polarisation VD+ sur une sortie 62 couplée à la source du troisième transistor T3, et la deuxième tension de polarisation VD- sur une deuxième sortie 63 couplée à la source du quatrième transistor T4.

Cette tension de polarisation différentielle VD+, VD- est destinée à l'étage d'élaboration 23 du courant de polarisation modulé en amplitude Imix.

L'étage d'élaboration 23 comprend un étage d'auto mélange 23a, un étage d'interface de polarisation 23b et des moyens de transmission 23c.

L'étage d'auto mélange 23a comprend deux paires différentielles de transistors P1, P2, quatre résistances RD1 à RD4, deux entrées E1, E2 et deux sorties S1, S2.

La première paire différentielle de transistors P1 comprend un premier transistor QA1 qui a sa source couplée à une première borne de la résistance RD1, son drain couplé à la première sortie S1, et sa grille couplée à la deuxième entrée 31 des moyens de modulation en amplitude 17. Le deuxième transistor QA2 de la première paire P1 a sa source couplée à une première borne de la deuxième résistance RD2, son drain couplé à la deuxième sortie S2, et sa grille est couplée à la première entrée 30 des moyens de modulation en amplitude 17. Les résistances RD1 et RD2 ont leur deuxième borne couplée à la première entrée E1.

La deuxième paire différentielle de transistors P2 comprend un premier transistor QA3 qui a sa source couplée à une première borne de la troisième résistance RD3, son drain couplé à la première sortie S1 et sa grille couplée à la grille du deuxième transistor QA2 de la première paire différentielle P1. Le deuxième transistor QA4 de la deuxième paire P2 a son drain couplé à la deuxième sortie S2, sa source couplée à une première borne de la quatrième résistance RD4 et sa grille couplée à la grille du premier transistor QA1 de la première paire P1. Les troisième et quatrième résistances RD3, RD4 ont leur deuxième borne couplée à la deuxième entrée E2.

L'étage d'interface de polarisation 23b permet de réaliser un gain de transconductance variable, il comprend deux paires différentielles de transistors P3, P4, quatre résistances RB1 à RB4 et quatre entrées EB1 à EB4.

La première paire différentielle P3 comprend un premier transistor QL+ qui a son drain couplé à la deuxième entrée E2 de l'étage d'auto mélange 23a, sa source couplée à une première borne de la première résistance RB1, et sa grille est couplée à la première entrée EB1 de l'étage d'interface de polarisation 23b. Le deuxième transistor QL- de la première paire P3 a son drain couplé à la première entrée E1 de l'étage d'auto mélange 23a, sa source couplée à une première borne de la deuxième résistance RB2 et sa grille couplée à la deuxième entrée EB2 de l'étage d'interface de polarisation 23b. Les première et deuxième résistances RB1, RB2 ont leur deuxième borne couplée à la masse 61.

La deuxième paire différentielle P4 de l'étage d'interface de polarisation 23b comprend deux transistors QH+, QH-. La troisième résistance RB3 est couplée entre la masse 61 et la source du transistor QH+, la quatrième résistance RB4 est couplée entre la masse 61 et la source du transistor QH-, et les transistors QH+, QH- ont leur drain couplés respectivement aux première et deuxième entrées E1, E2 de l'étage d'auto mélange 23a. La grille du transistor QH+ est couplée à la troisième entrée EB3 de l'étage d'interface de polarisation 23b, le transistor QH- a sa grille couplée à la quatrième entrée EB4 de l'étage d'interface de polarisation 23b.

L'étage d'interface de polarisation 23b comprend en outre quatre résistances supplémentaires RB5 à RB8 et quatre capacités CB1 à CB4.

La cinquième résistance RB5 est couplée entre la troisième entrée EB3 de l'étage d'interface de polarisation 23b et la première sortie 62 de l'étage de transformation de tension 22. La sixième résistance RB6 est couplée entre la quatrième entrée EB4 de l'étage d'interface de polarisation 23b et la première sortie 62 de l'étage de transformation de tension 22. La septième résistance RB7 est couplée entre la deuxième entrée EB2 de l'étage d'interface de polarisation 23b et la deuxième sortie 63 de l'étage de transformation de tension 22. La huitième résistance RB8 est couplée entre la première entrée EB1 de l'étage d'interface de polarisation 23b et la deuxième sortie 63 de l'étage de transformation de tension 22.

La première capacité CB1 est couplée entre la troisième entrée EB3 de l'étage d'interface de polarisation 23b et la première entrée 30 des moyens de modulation en amplitude 17. La deuxième capacité CB2 est couplée entre la quatrième entrée EB4 de l'étage d'interface de polarisation 23b et la deuxième entrée 31 des moyens de modulation en amplitude 17. La troisième capacité CB3 est couplée entre la deuxième entrée EB2 de l'étage d'interface de polarisation 23b et la deuxième entrée 31 des moyens de modulation en amplitude 17. La quatrième capacité CB4 est couplée entre la première entrée EB1 de l'étage d'interface de polarisation 23b et la première entrée 30 des moyens de modulation en amplitude 17.

Les moyens de transmission 23c comprennent six transistors MP1 à MP6.

Le premier transistor MP1 a sa source couplée à la tension d'alimentation Vcc, son drain et sa grille couplés à la première sortie S1 de l'étage d'auto mélange 23a. Le deuxième transistor MP2 a sa source couplée à la tension d'alimentation Vcc, son drain et sa grille couplés à la deuxième sortie S2 de l'étage d'auto mélange 23a. Le troisième transistor MP3 a sa source couplée à la tension d'alimentation Vcc, son drain couplé au drain du quatrième transistor MP4 et sa grille couplée à la grille et au drain du premier transistor MP1 et à la première sortie S1 de l'étage d'auto mélange 23a. Le quatrième transistor MP4 a sa source couplée à la masse 61 et sa grille couplée à son drain et à la grille du sixième transistor MP6. Le cinquième transistor MP5 a sa source couplée à la source du deuxième transistor MP2, son drain couplé à la sortie 34 des moyens de modulation en amplitude 17 et sa grille couplée à la deuxième sortie S2 de l'étage d'auto mélange 23a. Enfin, le sixième transistor MP6 a sa source couplée à la masse 61 et son drain couplé à la sortie 34 des moyens de modulation en amplitude 17.

L'étage d'auto mélange 23a est configuré pour déterminer le signal d'enveloppe à partir d'un auto mélange du signal radiofréquence différentiel RFe+, RFe-. Cet étage d'auto mélange 23a peut être un mélangeur à diodes ou préférentiellement à transistors QA1 à QA4.

De préférence, l'étage d'élaboration 23 comprend un mélangeur à cellule de Gilbert à gain variable, représenté sur la figure 3 par l'association du mélangeur à transistors 23a avec la première paire P3 de l'étage d'interface de polarisation 23b. Dans cette configuration, le gain variable peut varier tout en restant strictement positif uniquement.

En variante, l'étage d'élaboration 23 comprend un mélangeur à cellule de Gilbert modifié en associant le mélangeur à cellule de Gilbert 23a avec la deuxième paire P4 de l'étage d'interface de polarisation 23b. Dans cette configuration, le gain variable peut varier de manière positive et négative.

L'étage d'interface de polarisation 23b est configuré pour élaborer un gain variable β selon les équations (1) et (2) suivantes :

$$\beta = \frac{\partial^2 I_{mix}}{\partial Ve^2} \qquad \text{équation (1)}$$

$$\beta = M \cdot Ibias \cdot Aatt^2 \cdot \frac{Vcons}{8 \cdot Ut^3} \qquad \text{équation (2)}$$

- β: le gain variable des moyens de modulation en amplitude 17 ;
- Imix : le courant de polarisation modulé en amplitude ;
- Ve : la tension différentielle du signal radiofréquence RFe+, RFe- ;
- Aatt : le coefficient d'atténuation du diviseur capacitif 32 ;
- Ut : la tension thermique des transistors de l'étage de transformation de tension 22 ;
- Ibias : le courant de polarisation des transistors de l'étage de transformation de tension 22 ;
- M : le gain multiplicateur des transistors MP5 et MP6 des moyens de transmission 23c.

La consigne de tension variable Vcons dépend de la puissance moyenne du signal radiofréquence. Cette tension Vcons est variable, elle peut être positive, négative ou nulle. Par conséquent, le gain variable β peut être positif, négatif ou nul.

L'étage d'interface de polarisation 23b permet donc de polariser les transistors QA1 à QA4 de l'étage d'auto mélange de manière à moduler l'amplitude du signal d'enveloppe.

En d'autres termes, l'étage d'interface de polarisation 23b est configuré pour moduler l'amplitude du signal d'enveloppe.

En effet, lorsque la consigne de tension variable Vcons est positive, alors la tension VD- sera plus élevée que la tension VD+. Dans ce cas, on active graduellement les transistors QL+, QL- de la première paire P3 de transistors de l'étage d'interface de polarisation 23b et on dépolarise les transistors QH+, QH- de la deuxième paire P4 de transistors de l'étage d'interface de polarisation 23b, ce qui entraîne l'élaboration d'un β gain positif.

Au contraire, lorsque la consigne de tension variable Vcons est négative, alors la tension VD+ sera plus élevée que la tension VD-. Dans ce cas, on active graduellement les transistors QH+, QH- de la deuxième paire P4 de transistors de l'étage d'interface de polarisation 23b et on dépolarise les transistors QL+, QL- de la première paire P3 de transistors de l'étage d'interface de polarisation 23b, ce qui entraîne l'élaboration d'un β gain négatif.

En outre, les moyens de modulation d'amplitude 17 ainsi décrits sont particulièrement adaptés pour un téléphone mobile cellulaire car ils consomment peu de courant.

Les moyens de modulation en amplitude 17 permettent de délivrer un courant de polarisation modulé en amplitude Imix selon l'équation (3) suivante :

$$I_{mix}(f) = \beta(Vcons) \cdot |Ve|^2(f) \qquad \text{équation (3)}$$

- β(Vcons) : le gain variable des moyens de modulation en amplitude 17 en fonction de la consigne de tension variable Vcons ;
- f : fréquence du signal en bande de base ;
- Ve : la tension différentielle du signal radiofréquence RFe+, RFe-.

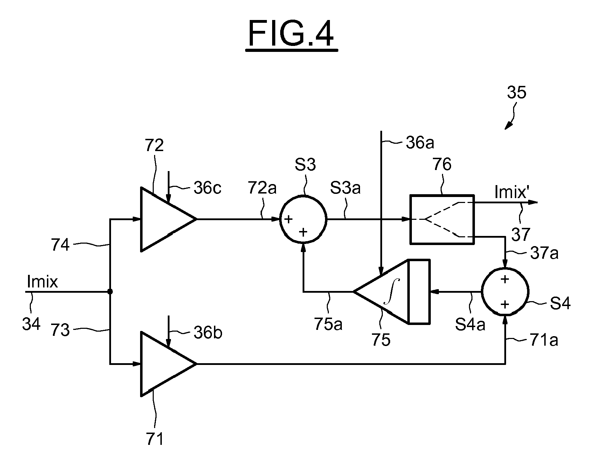

Sur la figure 4, on a représenté un mode de réalisation du filtre en bande de base 35. On a également reporté sur cette figure certaines références des figures précédentes.

Le filtre en bande de base comprend deux amplificateurs 71, 72 de gain en courant variable, réalisés par exemple à l'aide d'un miroir de courant à deux recopies de sortie. Le premier amplificateur 71 amplifie le courant de polarisation modulé en amplitude Imix, reçu par une connexion 73, à partir de la consigne de gain en courant -k0 reçu par la connexion 36b. Le deuxième amplificateur 72 amplifie le courant de polarisation modulé en amplitude Imix, reçu par une connexion 74, à partir de la consigne de gain en courant -k1 reçu par la connexion 36c.

Le filtre en bande de base 35 comprend également un filtre de type intégrateur 75, un deuxième miroir de courant 76 et deux moyens de sommation S3 et S4.

Le premier moyen de sommation S3 est configuré pour additionner le courant issu du deuxième amplificateur 72, via une connexion 72a, avec le courant issu du filtre de type intégrateur 75, via une connexion 75a, et pour transmettre le résultat au deuxième miroir de courant 76 via une connexion S3a.

Le deuxième miroir de courant 76 a un gain de préférence égal à -1 et il est configuré pour émettre le courant de polarisation modulé Imix' par la connexion 37 vers les moyens de sommation de courants 18 et par une connexion 37a vers le deuxième moyen de sommation S4.

Le deuxième moyen de sommation S4 est configuré pour additionner le courant issu du premier amplificateur 71, via une connexion 71 a, avec une image (ou une recopie) du courant de polarisation modulé Imix', via la connexion 37a, et pour transmettre le résultat au filtre de type intégrateur 75 via une connexion S4a.

Les moyens S3, S4, 75 et 76 constituent une boucle qui réalise à la fois les fonctions de différentiation et d'intégration.

Le filtre en bande de base 35 est configuré pour déphaser le courant de polarisation modulé en amplitude Imix et pour élaborer le courant de polarisation modulé en phase et en amplitude Imix' selon les équations (4 et 5) suivantes :

$$\mathrm{Im}ix'(f) = \mathrm{Im}ix(f) \cdot H(f) = \mathrm{Im}ix(f) \cdot k0 \cdot \frac{\left(1 + \dfrac{jf}{fz}\right)}{\left(1 + \dfrac{jf}{fp}\right)} \quad \text{équation (4)}$$

$$fz = fp \cdot \frac{k0}{k1} \qquad \text{équation (5)}$$

- H(f) : la fonction de transfert du filtre en bande de base 35 en fonction de la fréquence f ;
- k0, k1 : consignes de gain en courant variables des premier et deuxième amplificateurs ;

- jf : composante dans la représentation en complexe de la fréquence du courant de polarisation modulé en amplitude Imix ;
- fp : consigne de fréquence de coupure variable, notée consigne de fréquence de pôle, du filtre en bande de base 35 ;
- fz : fréquence de coupure variable, notée fréquence de zéro, du filtre en bande de base 35.

Lorsque k0 est strictement inférieure à k1, la fréquence de zéro fz du filtre en bande de base 35 est strictement inférieure à la consigne de fréquence de pôle fp du filtre en bande de base 35, et on élabore ainsi un courant de polarisation modulé Imix' avec une avance de phase par rapport à l'enveloppe du signal radiofréquence différentiel RFe+, RFe- pour la bande de fréquence comprise entre fz et fp.

Lorsque k0 est supérieure ou égal à k1, la fréquence de zéro fz du filtre en bande de base 35 est supérieure ou égale à la consigne de fréquence de pôle fp du filtre en bande de base 35, et on élabore ainsi un courant de polarisation modulé Imix' avec un retard de phase par rapport à l'enveloppe du signal radiofréquence différentiel RFe+, RFe-pour la bande de fréquence comprise entre fp et fz.

En faisant varier les valeurs des consignes de gain en courant k0, k1 on peut, soit créer une avance de phase, soit créer un retard de phase, sur le courant de polarisation modulé en amplitude Imix.

En faisant varier la consigne de fréquence de coupure fp, on modifie la bande passante du filtre 35 et on peut ainsi améliorer le lissage du courant de polarisation modulé en amplitude Imix.

Puis, après avoir appliqué le filtre en bande de base 35 au signal de polarisation modulé en amplitude Imix, on obtient le signal de polarisation filtré Imix' selon l'équation (6) suivante :

$$I_{mix}'(f) = H(f) \cdot \beta(Vcons) \cdot |Ve|^2 (f) \qquad \text{équation (6)}$$

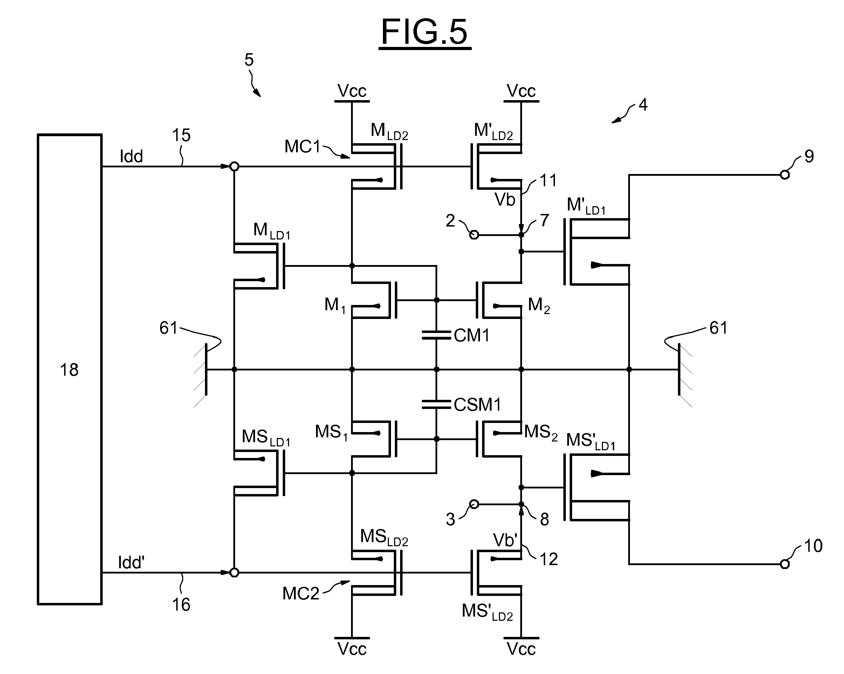

Sur la figure 5, on a représenté un mode de réalisation d'un étage de polarisation 5 et d'un étage d'amplification 4. On a également reporté sur cette figure certaines références des figures précédentes.

L'étage de polarisation 5 comprend trois transistors de polarisation MLD1, MLD2, M'LD2. L'étage d'amplification 4 comprend un transistor de puissance M'LD1 couplé entre la première sortie 7 de l'étage de polarisation 5 et la première sortie 9 de l'étage d'amplification 4. Les trois transistors de polarisation MLD1, MLD2, M'LD2 de l'étage de polarisation 5 forment avec le transistor de puissance M'LD1 une structure de miroir de courant MC1 avec un gain en courant N$_{puissance}$. Cette structure de miroir de courant MC1 est ainsi construite, le premier transistor de polarisation MLD1 a son drain couplé à la première sortie de traitement 15, sa source couplée à la masse 61, et sa grille couplée à la source du deuxième transistor de polarisation MLD2. Ce deuxième transistor de polarisation MLD2 a son drain couplé à la tension d'alimentation Vcc et sa grille couplée à la grille du troisième transistor de polarisation M'LD2.

Le troisième transistor de polarisation M'LD2 a son drain couplé à la tension d'alimentation Vcc et sa source couplée à la première sortie 11 de l'étage de polarisation 5. Le transistor de puissance M'LD1 a son drain couplé à la première sortie 9 de l'étage d'amplification 4, sa source couplée à la masse 61, et sa grille couplée à la première sortie 11 de l'étage de polarisation 5.

En outre, l'étage de polarisation 5 peut comprendre deux transistors de protection M1, M2 et une capacité CM1 montés de la façon suivante : le premier transistor de protection M1 a son drain couplé à la source du deuxième transistor de polarisation MLD2, sa source couplée à la masse 61, et sa grille couplée à son drain, à la capacité CM1 et à la grille du deuxième transistor de protection M2 ; le deuxième transistor de protection M2 a son drain couplé à la grille du transistor de puissance M'LD1, sa source couplée à la masse 61 ; et la capacité CM1 est également couplée à la masse 61. Ces transistors de protections M1, M2 protègent les transistors du miroir de courant MC1, notamment en les empêchant de saturer.

Dans le cas d'une architecture différentielle, on utilise des moyens analogues à ceux décrits ci-dessus pour le traitement du courant de polarisation modulé différentiel Idd' et du signal radiofréquence différentiel RFe-. Dans ce cas, l'étage de polarisation 5 comprend en outre trois transistors de polarisation supplémentaires MSLD1, MSLD2, MS'LD2. L'étage d'amplification 4 comprend en outre un deuxième transistor de puissance MS'LD1 couplé entre la deuxième sortie 12 de l'étage de polarisation 5 et la deuxième sortie 10 de l'étage d'amplification 4. Les trois transistors de polarisation supplémentaires MSLD1, MSLD2, MS'LD2 de l'étage de polarisation 5 forment avec le deuxième transistor de puissance MS'LD1 une deuxième structure de miroir de courant MC2 avec un gain en courant N$_{puissance}$. Cette deuxième structure de miroir de courant MC2 est ainsi construite : le premier transistor de polarisation supplémentaire MSLD1 a son drain couplé à la deuxième sortie de traitement 16, sa source couplée à la masse 61, et sa grille couplée à la source du deuxième transistor de polarisation supplémentaire MSLD2. Le deuxième transistor de polarisation supplémentaire MSLD2 a son drain couplé à la tension d'alimentation Vcc et sa grille couplée à la grille du troisième transistor de polarisation supplémentaire MS'LD2.

Le troisième transistor de polarisation supplémentaire MS'LD2 a son drain couplé à la tension d'alimentation Vcc et sa source couplée à la deuxième sortie 12 de l'étage de polarisation 5. Le deuxième transistor de puissance MS'LD1 a son drain couplé à la deuxième sortie 10 de l'étage d'amplification 4, sa source couplée à la masse 61, et sa grille couplée à la deuxième sortie 12 de l'étage de polarisation 5.

En outre, l'étage de polarisation 5 peut comprendre deux transistors de protection supplémentaires MS1, MS2 et une deuxième capacité CSM1 montés de la façon suivante : le premier transistor de protection supplémentaire MS1 a son drain couplé à la source du deuxième transistor de polarisation supplémentaires MSLD2, sa source couplée à la masse 61, et sa grille couplée à son drain, à la deuxième capacité CSM1 et à la grille du deuxième transistor de protection supplémentaire MS2 ; le deuxième transistor de protection supplémentaire MS2 a son drain couplé à la base du deuxième transistor de puissance MS'LD1, sa source couplée à la masse 61 ; et la deuxième capacité CSM1 est également couplée à la masse 61.

Ces transistors de protection supplémentaires MS1, MS2 protègent les transistors de la deuxième structure de miroir de courant MC2, notamment en les empêchant de saturer.

L'étage de polarisation 5 reçoit, depuis la première sortie de traitement 15, le courant de polarisation Idd modulé en phase et en amplitude selon l'équation (7) suivante :

$$Idd = \frac{I_{mix}'}{2} + \frac{Icons}{2} = \frac{I_{mix}'}{2} + \frac{Iddq}{2Npuissance} \qquad \text{équation (7)}$$

- Idd : le courant de polarisation modulé en phase et en amplitude ;
- Icons : la consigne de courant variable telle que :

$$Icons = Iddq / N_{puissance} ;$$

- $N_{puissance}$ : facteur de gain du miroir de courant MC1; et
- Iddq : somme des courants de repos des transistors de puissance M'LD1 et MS'LD1.

La consigne de courant variable Icons dépend des caractéristiques du ou des transistors de puissance de l'étage d'amplification 4, notamment du vieillissement des transistors. Ce courant Icons représente le seuil de fonctionnement du ou des transistors de puissance, c'est-à-dire le courant minimum qui doit être fourni pour que le ou les transistors de puissance fonctionnent.

Lorsque le signal radiofréquence RFe+ est appliqué, un courant de polarisation, ou courant en bande de base, fourni par le troisième transistor de polarisation M'LD2, augmente. La tension de grille Vb du transistor de puissance M'LD1 augmente également, ainsi que le courant consommé Id dudit transistor de puissance M'LD1 selon l'équation (8) suivante :

$$\Delta Id(f, Ve) = \alpha(f) \cdot |Ve|^2 (f) \qquad \text{équation (8)}$$

- $\alpha(f)$ : gain de transconductance de second ordre du transistor de puissance M'LD1 quand il est chargé à sa grille par la source du troisième transistor de polarisation M'LD2 ;
- $\Delta Id(f, Ve)$ : composante du courant consommé par le transistor de puissance M'LD1 générée par le troisième transistor de polarisation M'LD2.

Le courant consommé Id par le transistor de puissance M'LD1 est donné par les équations (9) et (10) suivantes :

$$Id(f, Ve) = \Delta Id(Ve) + (Npuissance \cdot Idd) \qquad \text{équation (9)}$$

$$Id(f,Ve) = \frac{Iddq}{2} + \left( \alpha(f) + \frac{Npuissance \cdot H(f) \cdot \beta(Vcons)}{2} \right) \cdot |Ve|^2(f)$$

équation (10)

Lorsqu'on amplifie le signal radiofréquence avec un courant de repos Iddq faible, des harmoniques parasites augmentent dans le signal amplifié RFs+, en particulier des harmoniques de troisième ordre.

Le fait d'utiliser un transistor de polarisation M'LD2 permet d'atténuer dans un premier temps ces harmoniques parasites. En effet, le troisième transistor de polarisation M'LD2 génère une composante en courant ΔId(f,Ve) qui est intermodulée avec le signal radiofréquence via les non-linéarités de second ordre du transistor de puissance M'LD1 et compense en partie les harmoniques de troisième ordre du signal amplifié RFs+.

A l'aide, notamment, du courant de polarisation modulé en phase et en amplitude Idd, on améliore l'atténuation des harmoniques du troisième ordre. En outre, à l'aide d'un gain variable β qui peut être positif ou négatif, on améliore l'atténuation quelle que soit la valeur de la puissance du signal radiofréquence. Par ailleurs, grâce au gain variable β, on peut remédier à une sous-polarisation ou une surpolarisation des transistors de puissance M'LD1, M'LD2. En effet, lorsque la puissance moyenne du signal radiofréquence RFe+ est faible, la consigne de tension variable Vcons est négative et génère un gain variable β négatif. Lorsque la puissance moyenne du signal radiofréquence RFe+ est élevée, la consigne de tension variable Vcons est positive et génère un gain variable β positif.

Avantageusement, lorsque la puissance moyenne du signal radiofréquence est faible, on diminue le courant de polarisation modulé Idd pour qu'il soit le plus faible possible et qu'il se rapproche du courant de consigne variable Icons.

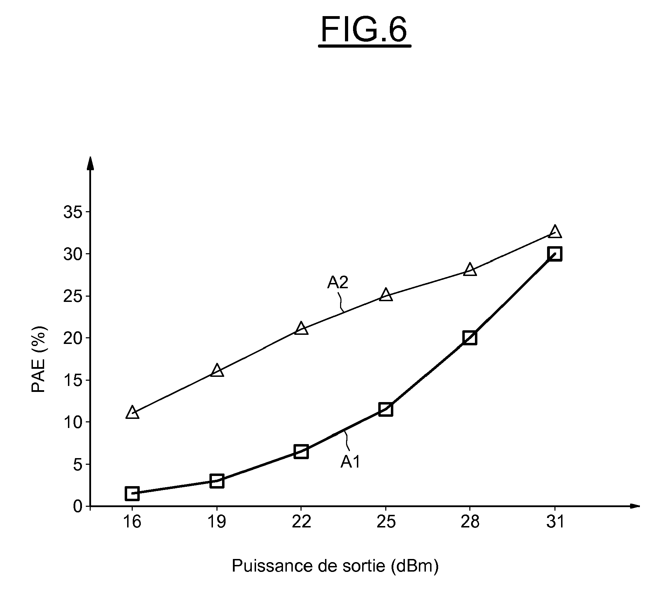

Sur la figure 6 on a représenté de façon schématique des courbes de rendement des transistors de puissance. Les courbes A1, A2 représentées permettent de comparer le comportement d'un transistor de puissance classique de classe A avec un transistor de puissance polarisé selon l'invention. Les courbes A1, A2 ont été obtenues à partir d'un signal deux tons espacés de 200 kHz. En abscisse on a représenté la puissance de sortie des transistors en dBm, c'est-à-dire en décibels (dB) référencées à un milliwatt. En ordonnée, on a représenté les valeurs des PAE, ou « Power Added Efficiency » en langue anglaise, ou Efficacité d'amplification de puissance, en pourcentage.

Le PAE s'exprime également selon l'équation (11) suivante :

$$PAE = 100 \cdot \frac{(Ps - Pe)}{Pc} \quad \text{équation (11)}$$

- PAE : l'efficacité d'amplification de puissance du transistor;
- Ps : la puissance du signal radiofréquence amplifié, ou la puissance du signal de sortie ;
- Pe : la puissance du signal radiofréquence en entrée du transistor ;
- Pc : la puissance consommée du transistor lors de l'amplification.

La première courbe A1 représente l'efficacité d'un transistor classique de classe A et la deuxième courbe A2 représente l'efficacité d'un transistor de puissance intégré dans un circuit d'amplification selon l'invention. On peut noter que lorsque le signal radiofréquence a une puissance faible, l'efficacité du transistor de puissance selon la deuxième courbe A2 est supérieure à celle du transistor classique de classe A.

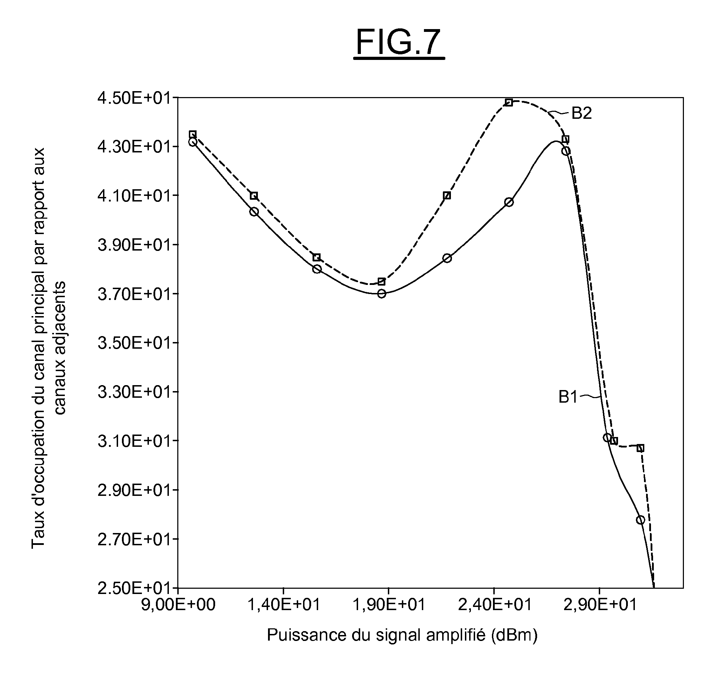

Sur la figure 7 on a représenté de façon schématique des courbes de linéarité des transistors de puissance. La linéarité des transistors est évaluée à partir de la mesure du taux d'occupation du canal principal par le signal radiofréquence par rapport aux canaux adjacents en fonction de la puissance du signal amplifié RFs+. Les courbes B1 et B2 représentées permettent de comparer la linéarité d'un transistor de puissance adaptatif classique avec un transistor de puissance polarisé selon l'invention.

La courbe B1 représente la linéarité d'un transistor de puissance adaptatif classique, avec la consigne de tension variable Vcons maintenue à une valeur nulle. Dans ce cas, le caractère adaptatif est pris en charge uniquement par le terme α(f) décrit dans l'équation (8).

La courbe B2 a été obtenue à partir d'une consigne de tension variable Vcons établie à partir d'une cartographie de tensions en fonction de la puissance du signal radiofréquence. En abscisse on a représenté la puissance du signal amplifié RFs+ en dBm, c'est-à-dire en décibels (dB) référencées à un milliwatt. En ordonnée, on a représenté le taux d'occupation du canal principal par le signal radiofréquence par rapport aux canaux adjacents.

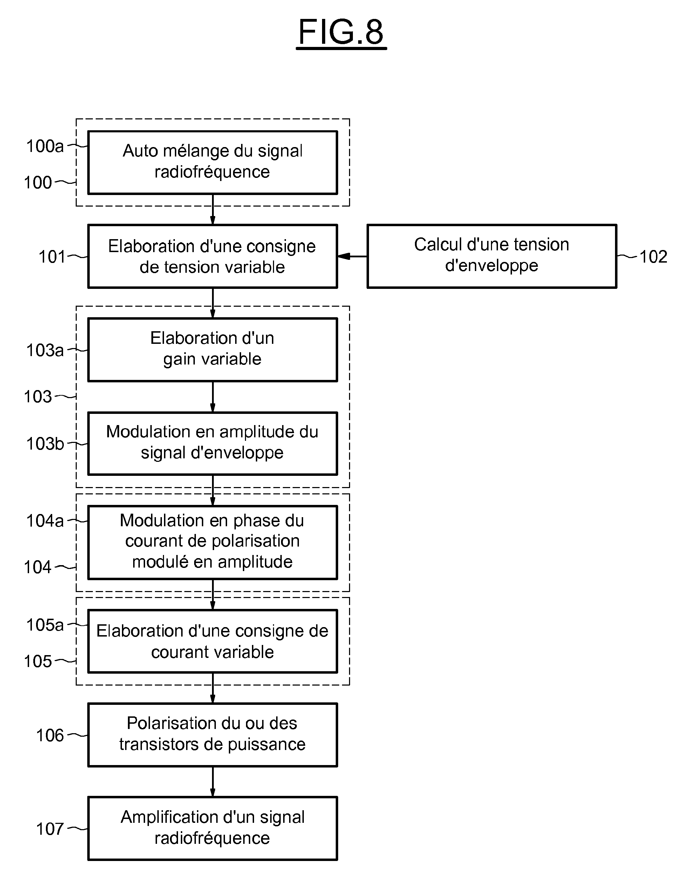

On notera que pour une puissance du signal amplifié donnée comprise entre environ 19 et 28 dBm, la modulation en amplitude à l'aide de la consigne de tension variable Vcons permet d'améliorer fortement la linéarité du transistor par rapport à un transistor adaptatif classique. Sur la figure 8, on a représenté un organigramme des étapes d'un procédé conforme à l'invention mis en oeuvre par le dispositif qui vient d'être décrit.

Ce procédé peut être implémenté dans un calculateur embarqué dans un appareil de communication sans fil, tel qu'un téléphone mobile cellulaire, sous forme logiciel ou également sous la forme de circuits logiques.

Dans une première étape 100, on détermine un signal d'enveloppe représentatif de l'enveloppe d'un signal radiofréquence. Cette étape de détermination 100 comprend une étape d'auto mélange 100a du signal radiofréquence afin de déterminer le signal d'enveloppe. Puis dans une deuxième étape 101, on élabore une consigne de tension variable. En variante, on effectue une étape 102 de calcul d'une tension d'enveloppe destinée à l'élaboration de la consigne de tension variable.

Puis, on effectue une quatrième étape 103 dans laquelle on élabore un courant de polarisation modulé en amplitude à partir du signal d'enveloppe et de la consigne de tension variable. Cette quatrième étape 103 comprend une étape 103a d'élaboration d'un gain variable et une étape de modulation 103b destinée à moduler en amplitude, à l'aide du gain variable élaboré, le signal d'enveloppe déterminé.

On effectue ensuite une cinquième étape 104 dans laquelle on élabore un courant de polarisation modulé en amplitude et en phase. Cette cinquième étape 104 comprend une modulation en phase 104a du courant de polarisation modulé en amplitude, par exemple un fitrage du courant de polarisation modulé en amplitude à partir de deux fréquences de coupure variable de manière à avancer ou retarder le courant de polarisation modulé par rapport à l'enveloppe du signal radiofréquence différentiel RFe+, RFe-.

Puis, on peut effectuer une sixième étape 105 dans laquelle on additionne le courant de polarisation modulé en amplitude et en phase avec une consigne de courant variable. Cette sixième étape 105 comprend une étape 105a dans laquelle on élabore la consigne de courant variable.

Enfin, on effectue une septième étape 106 dans laquelle on polarise un ou des transistors de puissance à partir du signal de polarisation modulé en amplitude et en phase, par exemple additionné de la consigne de courant variable, et l'on effectue une huitième étape 107 où l'on amplifie le signal radiofréquence à l'aide du ou des transistors de puissance ainsi polarisés.

## Revendications

1. Procédé d'amplification de puissance d'un signal radiofréquence comprenant une amplification (107) du signal radiofréquence avec au moins un transistor de puissance, **caractérisé en ce qu'**il comprend une détermination (100) d'un signal d'enveloppe représentatif de l'enveloppe du signal radiofréquence, une élaboration d'un courant de polarisation modulé au moins en amplitude (103) à partir du signal d'enveloppe et d'une consigne de tension variable, et une polarisation (106) du ou des transistors de puissance à partir du courant de polarisation modulé.

2. Procédé selon la revendication 1, dans lequel la détermination (100) du signal d'enveloppe comprend un auto mélange du signal radiofréquence (100a) et l'élaboration du courant de polarisation modulé au moins en amplitude (103) comprend une modulation (103b) en amplitude du signal d'enveloppe en utilisant la consigne de tension variable.

3. Procédé selon l'une des revendications 1 ou 2, comprenant une élaboration de la consigne de tension variable (101) à partir d'une cartographie établie en fonction de la puissance moyenne du signal radiofréquence.

4. Procédé selon l'une des revendications 1 ou 2, comprenant un calcul (102) d'une tension d'enveloppe du signal amplifié par le ou les transistors de puissance, et dans lequel la consigne de tension variable est élaborée à partir d'une consigne de tension en boucle ouverte et de la tension d'enveloppe calculée.

5. Procédé selon l'une des revendications 1 à 4, dans lequel l'élaboration du courant de polarisation modulé en amplitude (103) comprend en outre une élaboration (103a) d'un gain variable à partir de la consigne de tension variable, le courant de polarisation modulé en amplitude étant élaboré à partir du gain variable et du signal d'enveloppe.

6. Procédé selon l'une des revendications 1 à 5, comprenant une élaboration d'un courant de polarisation modulé en amplitude et en phase (104) à partir d'une modulation en phase (104a) du courant de polarisation modulé en amplitude, et une polarisation (106) du ou des transistors de puissance à partir du courant de polarisation modulé en amplitude et en phase.

7. Procédé selon la revendication 6, dans lequel la modulation en phase (104a) comprend une avance de phase ou un retard de phase du courant de polarisation modulé en amplitude par rapport à la phase de l'enveloppe du signal radiofréquence.

8. Procédé selon l'une des revendications 1 à 7, comprenant une addition (105) du courant de polarisation modulé avec une consigne de courant variable.

9. Procédé selon la revendication 8, comprenant une élaboration de la consigne de courant variable (105a) à partir d'une cartographie établie en fonction des caractéristiques du ou des transistors de puissance.

10. Circuit d'amplification de puissance d'un signal radiofréquence comprenant une entrée de signal (2) pour recevoir le signal radiofréquence, un étage d'amplification (4) couplé à l'entrée de signal (2) et possédant au moins un transistor de puissance, et un étage de polarisation (5) pour délivrer une tension de polarisation à l'étage d'amplification (4), **caractérisé en ce qu'**il comprend en outre un étage de traitement (6) comportant une entrée de traitement (13) couplée à l'entrée de signal (2), une sortie de traitement (15) pour délivrer un courant de polarisation modulé au moins en amplitude à l'étage de polarisation (5) et des moyens de modulation en amplitude (17) couplés entre l'entrée (13) et la sortie de traitement (15) et configurés pour déterminer un signal d'enveloppe représentatif de l'enveloppe du signal radiofréquence, pour moduler l'amplitude du signal d'enveloppe à partir d'une consigne de tension variable et pour élaborer le courant de polarisation modulé en amplitude à partir du signal d'enveloppe modulé.

11. Circuit selon la revendication 10, dans lequel les moyens de modulation en amplitude (17) comprennent un étage d'auto mélange (23a) du signal radiofréquence.

12. Circuit selon l'une des revendications 10 ou 11, dans lequel les moyens de modulation en amplitude (17) comprennent un étage d'interface de polarisation (23b) configuré pour élaborer un gain variable à partir de la consigne de tension variable, et pour moduler l'amplitude du signal d'enveloppe à partir du gain variable élaboré.

13. Circuit selon l'une des revendications 10 à 12, dans lequel l'étage de traitement (6) comprend des moyens (19) pour élaborer la consigne de tension variable à partir d'une cartographie établie en fonction de la puissance moyenne du signal radiofréquence.

14. Circuit selon l'une des revendications 10 à 12, dans lequel l'étage de traitement (6) comprend des moyens de soustraction (51) et des moyens de calcul (50) couplés entre la sortie de l'étage d'amplification (9) et les moyens de soustraction (51) et configurés pour calculer la tension d'enveloppe du signal amplifié par le ou les transistors de puissance, lesdits moyens de soustraction (51) étant configurés pour élaborer la consigne de tension variable à partir de la différence entre une consigne de tension en boucle ouverte et ladite tension d'enveloppe calculée.

15. Circuit selon l'une des revendications 10 à 14, dans lequel l'étage de traitement (6) comprend en outre des moyens de modulation en phase (35) couplés entre la sortie des moyens de modulation en amplitude (34) et la sortie de traitement (15) et configurés pour élaborer un courant de polarisation modulé en amplitude et en phase à partir du courant de polarisation modulé en amplitude.

16. Circuit selon la revendication 15, dans lequel les moyens de modulation en phase (35) comprennent un filtre, de type intégrateur et différentiateur ayant des fréquences de coupure variables par l'intermédiaire de deux gains en courant variables, afin de déphaser le courant de polarisation modulé en amplitude par rapport à la phase de l'enveloppe du signal radiofréquence.

17. Circuit selon l'une des revendications 10 à 16, dans lequel l'étage de traitement (6) comprend en outre des moyens de sommation de courants (18) couplés entre la sortie des moyens de modulation en phase (37) et la sortie des moyens de traitement (15) et configurés pour additionner le courant de polarisation modulé avec une consigne de courant variable.

18. Circuit selon la revendication 17, dans lequel l'étage de traitement (6) comprend des moyens (20) pour élaborer la consigne de courant variable à partir d'une cartographie établie en fonction des caractéristiques du ou des transistors de puissance.

19. Circuit selon l'une des revendications 10 à 18, dans lequel le ou les transistors de puissance comportent chacun une électrode de commande pour recevoir la tension de polarisation.

**20.** Circuit selon l'une des revendications 10 à 19, dans lequel l'étage de polarisation (5) comprend trois transistors qui forment, avec le transistor de puissance, une structure de miroir de courant ayant un facteur d'amplification en bande de base.

**21.** Circuit selon la revendication 20, dans lequel la structure de miroir de courant comprend une électrode de commande pour recevoir le courant de polarisation modulé.

**22.** Circuit selon l'une des revendications 10 à 21, possédant une architecture différentielle.

**23.** Appareil de communication sans fil comprenant un circuit d'amplification de puissance d'un signal radiofréquence selon l'une quelconque des revendications 10 à 22.

FIG.1

# FIG.2

EP 2 278 704 A1

FIG.3

EP 2 278 704 A1

# FIG.4

FIG.5

# FIG.6

EP 2 278 704 A1

# FIG.7

EP 2 278 704 A1

# FIG.8

100a — 100 —
Auto mélange du signal
radiofréquence

101 —
Elaboration d'une consigne
de tension variable
← 102
Calcul d'une tension
d'enveloppe

103a — 103 —
Elaboration d'un
gain variable

103b —
Modulation en amplitude du
signal d'enveloppe

104a — 104 —
Modulation en phase du
courant de polarisation
modulé en amplitude

105a — 105 —
Elaboration d'une consigne de
courant variable

106 —
Polarisation du ou des
transistors de puissance

107 —
Amplification d'un signal
radiofréquence

Europäisches
Patentamt

European
Patent Office

Office européen
des brevets

## RAPPORT DE RECHERCHE EUROPEENNE

Numéro de la demande

EP 10 17 0386

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2007/004343 A1 (KANDOLA GURMAIL [US] ET AL) 4 janvier 2007 (2007-01-04) * alinéas [0002], [0034] - [0037]; figure 6 * ----- | 1-23 | INV. H03F1/02 H03F3/24 |
| X | US 2007/013567 A1 (MATSUURA TORU [JP] ET AL) 18 janvier 2007 (2007-01-18) * alinéas [0085], [0086], [0102], [0110] - [0113], [0142] - [0146]; figures 1,5c,8,21-23 * ----- | 1-23 | |
| X | US 6 900 697 B1 (DOYLE JAMES T [US] ET AL) 31 mai 2005 (2005-05-31) * colonne 1, ligne 66 - colonne 2, ligne 12 * * colonne 7, ligne 12 - colonne 9, ligne 67; figure 4 * ----- | 1-23 | |
| | | | DOMAINES TECHNIQUES RECHERCHES (IPC) H03F |

Le présent rapport a été établi pour toutes les revendications

| Lieu de la recherche | Date d'achèvement de la recherche | Examinateur |
|---|---|---|
| La Haye | 7 octobre 2010 | Goethals, Filip |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

    ...........................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**

EP 10 17 0386

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

07-10-2010

| Document brevet cité au rapport de recherche | Date de publication | Membre(s) de la famille de brevet(s) | Date de publication |
|---|---|---|---|
| US 2007004343 A1 | 04-01-2007 | AUCUN | |
| US 2007013567 A1 | 18-01-2007 | EP 1881611 A1 | 23-01-2008 |
| | | WO 2007004518 A1 | 11-01-2007 |
| US 6900697 B1 | 31-05-2005 | AUCUN | |

EPO FORM P0460

Pour tout renseignement concernant cette annexe : voir Journal Officiel de l'Office européen des brevets, No.12/82